# EUROPÄISCHE PATENTSCHRIFT

(11) **EP 0 655 705 B1**
(45) Veröffentlichungstag und Bekanntmachung des Hinweises auf die Patenterteilung: **23.02.2000**
(21) Anmeldenummer: 94116834.6
(22) Anmeldetag: 25.10.1994
(51) Int. Cl.: G06K 19/077

(54) **Verfahren zur Herstellung von Ausweiskarten mit elektrischen Modulen**
Method for manufacturing identity cards having electronic modules
Méthode de fabrication de cartes d'identités comportant des modules électroniques

(30) Priorität: 26.10.1993 DE 4336501
(43) Veröffentlichungstag der Anmeldung: 31.05.1995
(73) Patentinhaber: Giesecke & Devrient GmbH, 81677 München (DE)
(72) Erfinder: Böttge, Horst, Dr., D-82538 Geretsried (DE); Gauch, Wolfgang, D-83624 Otterfing (DE); Hoppe, Joachim, D-81667 München (DE); Haghiri, Yahya, D-80797 München (DE)
(74) Vertreter: Klunker . Schmitt-Nilson . Hirsch

(56) Entgegenhaltungen:
- EP-A- 0 359 632
- EP-B- 0 484 353
- DE-A- 3 029 667
- DE-A- 3 123 198

## Beschreibung

Die Erfindung betrifft ein Verfahren zur Herstellung von Datenträgern mit elektronischen Modulen, wobei die elektronischen Module separat hergestellt werden und einen integrierten Schaltkreis und Kontaktflächen aufweisen, die leitend mit dem integrierten Schaltkreis verbunden sind.

Datenträger mit einem elektronischen Modul, das einen integrierten Schaltkreis enthält, sind seit langer Zeit bekannt und werden für die verschiedensten Anwendungen bereitgestellt. Im Laufe der Zeit sind unterschiedliche Techniken entwickelt worden, elektronische Module in Datenträger, wie beispielsweise Ausweiskarten oder Kreditkarten zu implantieren. Bei der sog. Montagetechnik wird zunächst ein Kartenkörper mit Aussparung gefertigt, in die das elektronische Modul in einem separaten Verfahrensschritt eingesetzt und verklebt wird. Bei einer anderen bekanntgewordenen Technik wird der Kartenkörper in Spritzgußtechnik hergestellt. Dabei besteht die Möglichkeit, Datenträger mit elektronischen Modulen in einem Verfahrensschritt zu fertigen, indem man das elektronische Modul in die Spritzgußform einlegt und umspritzt. Das elektronische Modul verfügt über Verankerungselemente, die von der Gußmasse umgossen werden, so daß ein Verbund zwischen Modul und Kartenkörper entsteht.

In Montagetechnik hergestellte Datenträger mit elektronischen Modulen sind beispielsweise aus der EP-A1-0 493 738 bekannt. Das elektronische Modul besteht aus einem Trägerfilm, der auf einer Seite eine leitende Beschichtung aufweist, in der durch Unterbrechungen Kontaktflächen ausgebildet sind. Darüber hinaus weist der Trägerfilm entsprechend positionierte Fenster zur Aufnahme des integrierten Schaltkreises und zur Hindurchführung der leitenden Verbindungen vom Schaltkreis zu den Kontaktflächen auf. Der Schaltkreis und die leitenden Verbindungen sind mit einer Gußmasse derart vergossen, daß sie vollständig umhüllt sind, aber ein Teil des Trägerfilms von Gußmasse freibleibt. Dieser kann zum Aufkleben eines thermoaktivierbaren Kleberings genutzt werden, wobei das Fenster in dem Klebering so dimensioniert ist, daß zumindest ein Teil der tropfenförmigen Gußmasse von ihm bedeckt wird. Das elektronische Modul wird mittels des Kleberings in eine zweistufige Aussparung des Kartenkörpers eingeklebt. Hierbei liegt im oberen Teil der Aussparung im wesentlichen der Trägerfilm und im unteren Teil der Aussparung im wesentlichen die Gußmasse. Der Klebering liegt auf der Schulter der Aussparung. Durch seine Dimensionierung ist sichergestellt, daß die Schulter ganzflächig von ihm bedeckt wird, so daß eine gute und dauerhafte Verbindung zwischen dem Modul und dem Kartenkörper entsteht.

In Spritzgußtechnik hergestellte Ausweiskarten mit elektronischem Modul sind beispielsweise aus der EP-A2-0 399 868 bekannt. Das elektronische Modul enthält ein aus einem Metallband ausgestanztes Kontakt-Layout, auf das der integrierte Schaltkreis aufgeklebt und leitend mit den Kontaktflächen des Kontakt-Layouts verbunden wird. Der Schaltkreis und die leitenden Verbindungen werden auch hier zum Schutz vor mechanischen Belastungen mit einer Gußmasse vergossen. Der Gußkörper ist so ausgebildet, daß ein Teil des Kontakt-Layouts über seinen Rand hinausragt. Das elektronische Modul wird in eine Spritzgußform eingelegt und mit Positionier- und Fixierelementen in seiner Lage gehalten. Danach wird zur Bildung des Datenträgers das elektronische Modul mit Kunststoffmasse umspritzt. Das Modul wird mittels des Teils des Kontakt-Layouts, der über den Rand der Gußmasse hinausragt, im Kartenkörper verankert. Eine besonders feste und dauerhafte Verankerung des elektronischen Moduls im Kartenkörper wird erzielt, wenn der über den Rand der Gußmasse hinausragende Teil des Kontakt-Layouts gekröpft wird, so daß das Kontakt-Layout die Form eines Hutes annimmt und die Verankerung des Moduls somit im Inneren des Kartenkörpers vorgenommen wird. Der über den Rand der Gußmasse hinausstehende Teil des Kontakt-Layouts dient ausschließlich der Verankerung des elektronischen Moduls im Kartenkörper.

Die aus dem Stand der Technik bekannten Module sind an das jeweilige Herstellungsverfahren der Karten optimal angepaßt. Dies bedeutet einerseits, daß weitestgehend optimierte Karten bezüglich der Verbundfestigkeit zwischen dem elektronischen Modul und dem Kartenkörper hergestellt werden können. Andererseits bedeutet die optimale Anpassung der elektronischen Module an die Herstellungsverfahren, daß die elektronischen Module grundsätzlich verschieden sind und daß das an sich separate Herstellungsverfahren der elektronischen Module abhängig von dem Herstellungsverfahren der Karte ist. Das heißt, daß bereits bei der Herstellung des elektronischen Moduls feststehen muß, in welcher Technik die Karte, in die das Modul eingesetzt wird, hergestellt wird. Andererseits ist auf Seiten der Kartenherstellung für jede Kartentechnologie ein speziell gefertigtes Modul bereitzustellen. Die Flexibilität in der Produktion ist sowohl in der Modul- als auch in der Kartenfertigung eingeschränkt.

EP-B1-0 484 353 offenbart eine Bandherstellung von Modulen, die ein Struktur aufweisen, die sich grundsätzlich gleichermaßen für eine kartenherstellung in Montage- wie in Laminiertechnik eignet.

Es ist deshalb Aufgabe der Erfindung, ein Verfahren vorzustellen, das sowohl in der Modul- als auch in der Kartenfertigung eine höhere Flexibilität ermöglicht, was letztlich zu einem kostengünstigeren Produkt führt.

Die Aufgabe wird durch die Merkmale des Hauptanspruchs gelöst.

Der Grundgedanke der Erfindung ist es, zunächst ein Modulband mit neutralen elektronischen Modulen zu fertigen und das elektronische Modul erst in einem letzten Verfahrensschritt an die Kartenherstellungstechnik zu adaptieren. Hierbei kann der letzte Verfahrensschritt entweder beim Modulhersteller oder beim Kartenhersteller erfolgen und sollte vorzugsweise möglichst einfach durchzuführen sein.

Die mit der Erfindung erzielten Vorteile bestehen insbesondere darin, daß die Modulherstellung vollkommen unabhängig von der Kartenherstellung wird. Dadurch wird eine Fertigung des Moduls von einem anderen Hersteller als der Karte, wie es heute häufig der Fall ist, wesentlich erleichtert. Die Module können von diesem Hersteller in beliebig honen Stückzahlen hergestellt und gelagert werden, da sie von allen Ausweiskartenherstellern geordert und weiterverarbeitet werden können. Ferner braucht für die Herstellung der nicht adaptierten elektronischen Module, unabhängig davon, wie sie weiterverarbeitet werden, nur ein Werkzeug bereitgestellt zu werden, so daß die Kosten für das Modul gesenkt werden können. Da die elektronischen Module in einem letzten Verfahrensschritt adaptiert werden, sind sie nach wie vor optimal an ihre Weiterverarbeitungstechnik angepaßt, so daß die Ausweiskarten ohne Qualitätseinbußen gefertigt werden können.

Weitere Eigenschaften und Vorteile der Erfindung ergeben sich aus den Unteransprüchen und der nachfolgenden Beschreibung verschiedener Ausführungsbeispiele, die anhand der Zeichnung näher erläutert sind, darin zeigt:
- Fig. 1: ein schematisches Flußdiagramm mehrerer Produktionsläufe
- Fig. 2 - 4: Modulbänder mit elektronischen Modulen

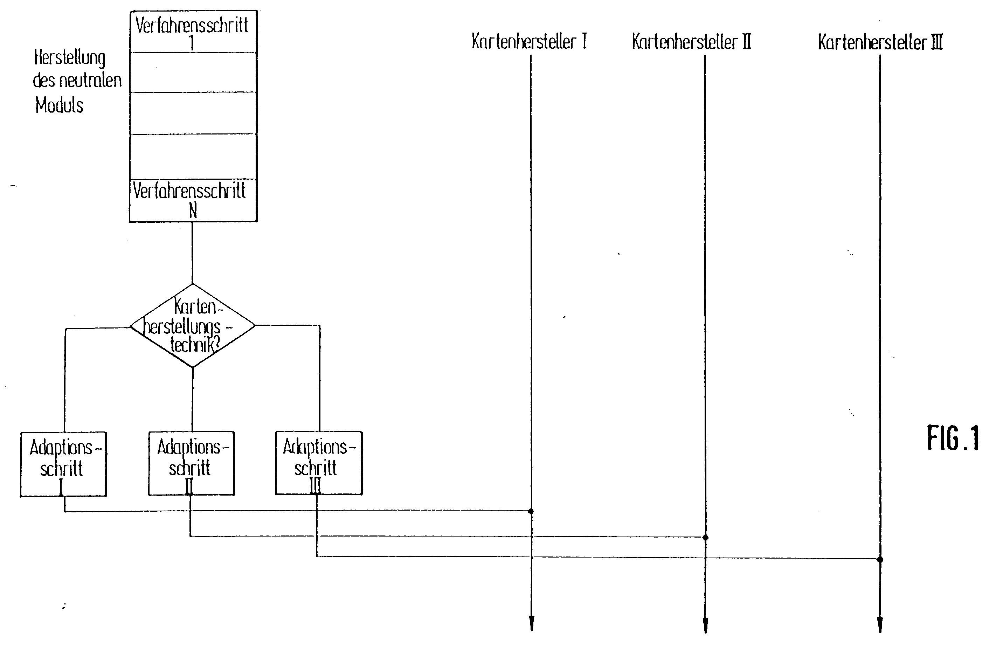

Fig. 1 zeigt schematisch die Herstellung eines elektronischen Moduls und die Weiterverarbeitung dieses elektronischen Moduls bei verschiedenen Kartenherstellern. Bei einem Hersteller von elektronischen Modulen wird in den Verfahrensschritten 1 - N zunächst ein Modulband, das einzelne elektronische Module enthält, hergestellt (siehe Fig. 1 links oben). Die Verfahrensschritte 1 - N können durchaus von Modulhersteller zu Modulhersteller differieren, wichtig ist lediglich, daß in diesen Verfahrensschritten ein Modulband mit elektronischen Modulen gefertigt wird, die zunächst neutral bezüglich der Weiterverarbeitungstechnik sind und sich in einem letzten zusätzlichen Verfahrensschritt an die Kartenherstellungstechnik anpassen lassen. Nach Fertigstellung des Modulbandes mit den neutralen elektronischen Modulen wird zunächst darüber entschieden, in welcher Kartenherstellungstechnik das elektronische Modul weiterverarbeitet werden soll. Abhängig von der Weiterverarbeitungstechnik wird an den elektronischen Modul ein weiterer Verfahrensschritt durchgeführt, der in der Fig. 1 als Adaptionsschritt bezeichnet ist. Durch den Adaptionsschritt I wird das neutrale elektronische Modul beispielsweise an die Kartenherstellungstechnik I angepaßt, also z.B. an die Spritzgußtechnik. Durch die Adaptionsschritte II und III wird das neutrale elektronische Modul an weitere Herstellungstechniken angepaßt, wie z. B. an die Montagetechnik und an die Laminiertechnik, bei der das Modul in einem mehrschichtigen Kartenaufbau eingefügt und beim Laminieren der Kartenschichten mit den Kartenkörper verbunden wird. Die Anpassung des elektronischen Moduls an eine gewisse Herstellungstechnik kann so geschehen, daß man in der Herstellungstechnik selbst noch gewisse Freiheitsgrade hat. So ist es beispielsweise möglich, ein neutrales elektronisches Modul so an die Montagetechnik anzupassen, daß es wahlweise mit einem Flüssigkleber, einem Haftkleber oder einem thermoaktivierbaren Kleber in die Aussparung eines Kartenkörpers eingeklebt werden kann.

Die obengenannten Adaptionsschritte können entweder bereits beim Modulhersteller oder aber beim Kartenhersteller durchgeführt werden. Besonders vorteilhaft ist es, wenn der Adaptionsschritt möglichst einfach durchzuführen ist. Durch das in der Fig. 1 schematisch gezeigte Verfahren wird erreicht, daß die Herstellung des elektronischen Moduls vollkommen unabhängig von der Herstellung der Ausweiskarte ist.

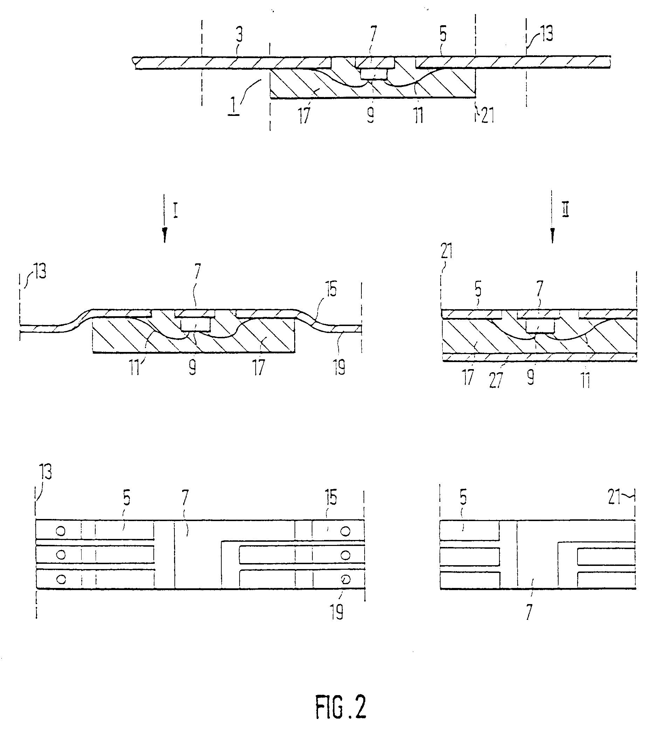

Die Figuren 2 bis 4 zeigen besondere Ausgestaltungen von Modulbändern mit elektronischen Modulen, die in den Verfahrensschritten 1 bis N gefertigt worden sind, und den jeweiligen Adaptionsschritt an die Herstellungstechnik der Karte. Wie bereits erwähnt, können sich die Verfahrensschritte 1 bis N unterscheiden, sie führen jedoch immer zu einem Modulband mit neutralen elektronischen Modulen.

In Fig. 2 ist ein Modulband 1 gezeigt, das beim Modulhersteller in den Verfahrensschritten 1 bisN wie folgt gefertigt wird. Aus einem Metallband 3 werden zunächst in äquidistanten Abständen die Kontaktflächen 5 ausgestanzt, von denen eine in einen zwischen den Kontaktflächen 5 liegenden Mittelsteg 7 ausläuft. Die Kontaktflächen 5 sind zunächst noch über Stege mit dem Metallband verbunden. Auf die Mittelstege 7 wird jeweils ein integrierter Schaltkreis aufgeklebt und, z.B. durch Leiterbahnen 11, leitend mit den Kontaktflächen verbunden. Das so vorbereitete Metallband wird durch eine Spritzgußform geführt, in der der Schaltkreis 9 und die leitenden Verbindungen 11 blockförmig vergossen werden.

Danach sind die Verfahrensschritte 1 - N abgeschlossen (siehe Fig. 1) und das Modulband fertiggestellt, so daß es an die verschiedenen Kartenhersteller ausgeliefert werden kann.

Der Hersteller, der die Karten in Spritzgußtechnik fertigt, führt nunmehr einen Adaptionsschritt durch, mit dem das elektronische Modul für die Spritzgußtechnik spezifiziert wird (Zweig I in Fig. 2). Dazu stanzt er die einzelnen Module entlang der Stanzkanten 13 aus dem Modulband aus, so daß bei den einzelnen Modulen Verlängerungen 15 der Kontaktflächen 5 über den Gußkörper 17 hinausragen. Bei dem Stanzvorgang können in den Verlängerungen der Kontaktflächen gleichzeitig Fenster 19 erzeugt werden. Schließlich werden in einem letzten Verfahrensschritt die Verlängerungen 15, wie in der Figur gezeigt, gekröpft. Dieser Verfahrensschritt kann gegebenenfalls auch mit dem Stanzvorgang gleichzeitig erfolgen. Das nunmehr adaptierte elektronische Modul kann jetzt, wie an sich bekannt, in Spritzgußtechnik weiterverarbeitet werden.

Der Hersteller, der die Karte in Montagetechnik fertigt, führt ebenfalls einen Adaptionsschritt aus, der das Modul für die Montagetechnik spezifiziert (Zweig II in Fig. 2) . Dieser Adaptionsschritt unterscheidet sich jedoch von dem oben genannten Adaptionsschritt. Zunächst werden die einzelnen Module entlang der Stanzkante 21 ausgestanzt und in einem letzten Verfahrensschritt mit einem Kleber 27 versehen, der als Haft- oder thermoaktivierbarer Kleber ausgebildet sein kann. Das nunmehr fertiggestellte elektronische Modul kann gemäß der Montagetechnik in die Aussparung eines bereitgestellten Kartenkörpers eingesetzt und dort verklebt werden.

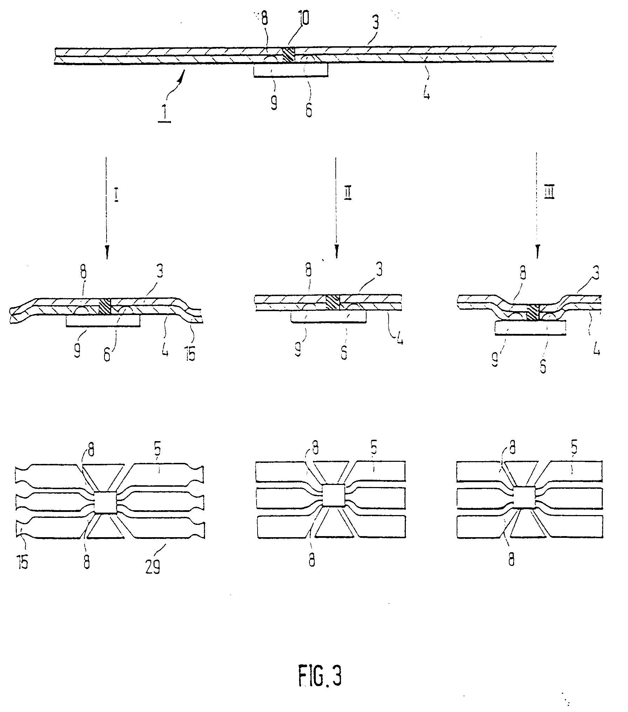

Fig. 3 zeigt ein weiteres Modulband 1, das in den Verfahrensschritten 1 bis N bei dem Modulhersteller gefertigt werden kann. Aus einem Metallband 3 werden zunächst, genau wie in Fig. 2 in äquidistanten Abständen die Kontaktflächen 5 ausgestanzt, die zunächst über Stege mit dem Metallband verbunden bleiben. Danach wird das Metallband gegebenenfalls mit einem Klebeband 4 zusammengeführt und verklebt. Das Klebeband 4 enthält in äquidistanten Abständen Fenster, durch die die Kontakthöcker 6 des Schaltkreises 9 geführt und mit den Kontaktfingern 8 der Kontaktflächen 5 leitend verbunden werden. Der Schaltkreis 9 wird hierbei zum Teil auf das Klebeband 4 aufgeklebt. Schließlich wird der Bereich zwischen den Kontakthöckern 6 von der Seite des Metallbandes 3 zumindest zum Teil mit einem Harz 10 vergossen. Auf ein Vergießen des Schaltkreises kann in diesem Ausführungsbeispiel verzichtet werden, da keine empfindlichen Leiterbahnen, die den Schaltkreis mit den Kontaktflächen verbinden, vorhanden sind. Das fertiggestellte Modulband kann nunmehr an den Kartenhersteller ausgeliefert werden.

Wenn das elektronische Modul in Spritzgußtechnik weiterverarbeitet werden soll, wird es weitestgehend, wie in Fig. 2 bereits gezeigt, an diese Technik adaptiert (siehe Zweig I in Fig. 3). Die über die Kontaktflächen 5 hinausragenden Verlängerungen 15 können schwalbenschwanzartig ausgebildet sein (siehe Aufsicht 29), so daß bereits durch diese Formgebung eine Verankerung in einem spritzgegossenen Kartenkörper möglich ist.

Wenn das elektronische Modul in Montagetechnik weiterverarbeitet werden soll, wird es entlang der Kontaktflächen aus dem Modulband ausgestanzt, die Verlängerungen 15 befinden sich also nicht mehr an dem Modul (siehe Zeig II in Fig. 3). Das einzelne Modul kann nunmehr mit Hilfe des Klebers 4, der als Haftkleber, thermoaktivierbarer Kleber, Thermoplast oder als eine Folie mit Klebeschicht ausgebildet sein kann, in eine zweistufige Aussparung eines bereitgestellten Kartenkörpers eingeklebt werden. Falls bei der Herstellung des Modulbandes auf das Klebeband 4 verzichtet wird, kann das elektronische Modul beispielsweise auch mit einem Flüssigkleber in die Aussparung eingeklebt werden, die punktweise auf den Kontaktflächen aufgebracht wird und sich beim Einkleben unter den Kontaktflächen verteilt.

Wenn das elektronische Modul in Laminiertechnik weiterverarbeitet werden soll (siehe Zweig III in Fig. 3), wird es ebenfalls entlang der Kontaktflächen aus dem Modulband ausgestanzt. Im Gegensatz zur Montagetechnik werden die Kontaktflächen hier aber leicht nach oben gekröpft, so daß das elektronische Modul in einen mehrschichtigen Kartenaufbau einlaminiert werden kann. Dies kann beispielsweise dadurch geschehen, daß man eine Schicht mit Fenstern für die nach oben gekröpften Kontaktflächen, eine weitere Schicht mit einem Fenster zur Aufnahme des integrierten Schaltkreises und eine durchgehende Schicht bereitstellt. In diesen Schichtaufbau wird das elektronische Modul entsprechend eingelegt, wonach die Schichten durch Laminieren miteinander verbunden werden und ein fertiger Datenträger entsteht. Auf das separate Kröpfen der Schichten kann gegebenenfalls verzichtet werden, da die Kontaktflächen durch den oben beschriebenen Schichtaufbau beim Laminieren automatisch an die Oberfläche der Karte gedrückt werden.

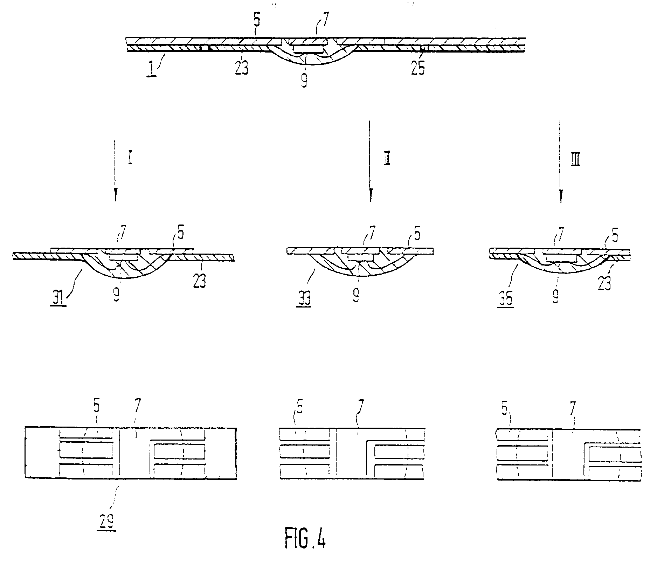

Fig. 4 zeigt ein weiteres Ausführungsbeispiel für ein Modulband 1, das in den Verfahrensschritten 1 bis N gefertigt wird. Es wird wiederum ein Metallband 3 bereitgestellt, aus dem zunächst die Kontaktflächen 5 ausgestanzt werden, die zunächst noch über Stege mit dem Metallband verbunden bleiben. Danach wird das Metallband mit einer Trägerfolie 23 lösbar versehen, die im Zentralbereich der Kontaktflächen 5 ein Fenster enthält und jenseits der Kontaktflächen angestanzt ist (siehe Spalt 25 in Fig.4). In einem weiteren Schritt werden, wie in der Fig. 4 gezeigt, Schaltkreise 9 in das Fenster der Trägerfolie 23 auf das Metallband geklebt und leitend mit den Kontakthöckern verbunden. Schließlich werden der Schaltkreis und die leitenden Verbindungen mit einer Gußmasse vergossen, die hier tropfenförmig ausgebildet ist. Dabei kann die Begrenzung des Fensters in der Trägerfolie 23 als Begrenzungsrahmen für die Gußmasse dienen.

Wenn das nunmehr fertiggestellte elektronische Modul in Spritzgußtechnik oder Laminiertechnik (siehe Zweig I in Fig. 4) weiterverarbeitet werden soll, wird zunächst das Metallband 3 im Bereich der Kontaktflächen 5 innig mit der Trägerfolie verbunden. Danach werden die Stege, die die Kontaktflächen 5 noch mit den Metallband verbinden und die Stege im Bereich 25, die die Trägerfolienelemente noch miteinander verbinden, durchstanzt, so daß ein einzelnes elektronisches Modul, wie es die Seitenansicht 31 bzw. die Aufsicht 29 zeigt, entsteht. Bei diesem Modul dient der über die Kontaktflächen hinausragende Teil der Trägerfolie 23 als Verankerungsrahmen, der sowohl zur Verankerung des elektronischen Moduls in Spritzgußkarten als auch zur Verankerung des Moduls in laminierten Mehrschichtkarten genutzt werden kann. Gegebenenfalls kann der Verankerungsrahmen noch mit Fenstern versehen werden, was eine bessere Verankerung ermöglicht.

Wenn das elektronische Modul in der Montagetechnik weiterverarbeitet werden soll, bestehen zwei Möglichkeiten (Zweig II und III), es an die Technik anzupassen. Entweder wird das Modul direkt von der Trägerfolie abgehoben, so daß ein einzelnes Modul, so wie es die Seitenansicht 33 zeigt, entsteht. Dieses Modul kann mit Hilfe eines Flüssigklebers in eine zweistufige Aussparung eines bereitgestellten Kartenkörpers eingeklebt werden. Bei entsprechend dünner Ausbildung des Metallbandes 3 bzw. der Kontaktflächen 5 ist es auch möglich, die Gußmasse des Moduls in ein Sackloch eines Kartenkörpers einzusetzen und die Kontaktflächen direkt auf der Oberfläche der Karte zu verkleben.

Eine weitere Möglichkeit (Zweig III) besteht darin, das Metallband 3 wiederum im Bereich der Kontaktflächen 5 mit der Trägerfolie 23 innig miteinander zu verbinden und das elektronische Modul entlang der Kontaktflächen auszustanzen, so daß ein einzelnes Modul, wie es die Seitenansicht 35 zeigt, entsteht. Das so entstandene Modul kann wiederum in eine zweistufige Aussparung eingeklebt werden, was nunmehr mit Hilfe des Trägerfolienrings 23 geschehen kann, der dazu z.B. mit einer thermoaktivierbaren Klebeschicht versehen sein kann.

## Patentansprüche

1. Verfahren zur Herstellung von Datenträgern mit elektronischen Modulen, wobei die elektronischen Module separat hergestellt werden und einen integrierten Schaltkreis sowie leitend mit dem integrierten Schaltkreis verbundene Kontaktflächen aufweisen, **gekennzeichnet** durch folgende Schritte:
- Ausführen einer Verfahrensschrittfolge zur Herstellung eines Bandes, das vollständig neutrale elektronische Module enthält, welche in unterschiedlichen Techniken mit einem Kartenkörper verbindbar sind,
- Ausführen einer das neutrale elektronische Modul für eine bestimmte Technik zur Verbindung mit einem Kartenkörper spezifizierenden Adaptationsschrittfolge, welche zumindest einen Schritt zum auf die gewählte Verbindungstechnik abgestimmten Herauslösen des Moduls aus dem Band umfaßt, durch den das Modul eine auf die gewählte Verbindungstechnik abgestimmte äußere Gestalt erhält, und
- Verbinden des adaptierten elektronischen Moduls gemäß der gewählten Verbindungstechnik mit dem Kartenkörper.

2. Verfahren zur Herstellung von Datenträgern nach Anspruch 1, dadurch **gekennzeichnet**, daß die Reihe der Verfahrensschritte, in denen das Band gefertigt wird, zumindest folgende Schritte umfaßt:
- Bereitstellung eines Metallbandes, aus dem die Kontaktflächen derart ausgestanzt werden, daß sie zunächst noch über Stege mit dem Metallband verbunden bleiben
- Anordnen eines integrierten Schaltkreises auf einer Gruppe von Kontaktflächen, die für ein elektronisches Modul benötigt werden und leitendes Verbinden der Kontaktflächen mit dem integrierten Schaltkreis
und daß der Verfahrensschritt zum auf die gewählte Verbindungstechnik abgestimmten Herauslösen des Moduls aus dem Band darin besteht,
- daß man die Stege durchtrennt, die das Modul mit dem Band verbinden und daß man für mindestens eine Einbautechnik das Modul entlang der Kontaktflächen aus dem Band herausstanzt und für mindestens eine weitere Einbautechnik das Modul entlang eines Bereiches ausstanzt, der über die Kontaktflächen hinausragt.

3. Verfahren zur Herstellung von Datenträgern nach den Ansprüchen 1 bis 2, dadurch **gekennzeichnet,** daß, wenn man das Modul entlang der Kontaktflächen aus dem Band herausstanzt, das Modul in die Aussparung eines bereitgestellten Kartenkörpers eingeklebt wird und daß, wenn man das Modul entlang eines Bereiches herausstanzt, der über die Kontaktflächen hinausragt, das Modul zur Bildung einer Karte mit einer Kunststoffmasse umspritzt wird, bzw. daß das Modul in einen mehrschichtigen Anbau eingebracht wird, der zusammen mit dem Modul zu einer Karte laminiert wird.

4. Verfahren zur Herstellung von Datenträgern nach den Ansprüchen 1 bis 3, dadurch **gekennzeichnet**, daß, wenn das Modul in die Aussparung eines bereitliegenden Kartenkörpers eingeklebt wird, dies mittels eines Haft- oder thermoaktivierbaren Klebers geschieht, der sich bereits am elektronischen Modul befindet.

5. Verfahren zur Herstellung von Datenträgern nach den Ansprüchen 1 bis 3, dadurch **gekennzeichnet**, daß, wenn das Modul in die Aussparung eines bereitgestellten Kartenkörpers eingeklebt wird, dies mittels eines Flüssigklebers geschieht, der die Kontaktflächen direkt mit dem Kartenkörper verbindet.

6. Verfahren zur Herstellung von Datenträgern nach den Ansprüchen 1 bis 3, dadurch **gekennzeichnet,** daß der über die Kontaktflächen hinausragende Bereich aus Verlängerungen der Kontaktflächen besteht und in Richtung des integrierten Schaltkreises gekröpft wird, um das elektronische Modul beim Umspritzen mit einer Kunststoffmasse im Karteninnern zu verankern.

7. Verfahren zur Herstellung von Datenträgern nach den Ansprüchen 1 bis 3, dadurch **gekennzeichnet**, daß der über die Kontaktflächen hinausragende Bereich durch eine separate Schicht gebildet wird, auf der die Kontaktflächen aufliegen.

8. Verfahren zur Herstellung von Datenträgern nach den Ansprüchen 5 bis 6, dadurch **gekennzeichnet,** daß der über die Kontaktflächen hinausragende Bereich mit Fenstern versehen ist, die beim Verankern des elektronischen Moduls in dem Kartenkörper vom Kartenmaterial durchdrungen werden.

## Claims

1. A method for producing data carriers having electronic modules, the electronic modules being produced separately and having an integrated circuit and contact surfaces electrically connected with the integrated circuit, characterized by the following steps:
- performing a sequence of method steps to produce a band containing completely neutral electronic modules to be connected with a card body by different techniques,
- performing a sequence of adapting steps specifying the neutral electronic module for a certain technique for connection with a card body, the sequence including at least one step for detaching the module from the band in a way coordinated with the selected connecting technique, thereby giving the module an external form coordinated with the selected connecting technique, and
- connecting the adapted electronic module with the card body by the selected connecting technique.

2. A method for producing data carriers according to claim 1, characterized in that the series of method steps in which the band is produced includes at least the following steps:
- preparing a metal band from which the contact surfaces are stamped such that they initially remain connected with the metal band by bars,
- disposing an integrated circuit on a group of contact surfaces required for an electronic module and electrically connecting the contact surfaces with the integrated circuit,
and the method step for detaching the module from the band in a way coordinated with the selected connecting technique consists in
- severing the bars connecting the module with the band, and for at least one incorporation technique stamping the module out of the band along the contact surfaces, and for at least one further incorporation technique stamping the module out along an area protruding beyond the contact surfaces..

3. A method for producing data carriers according to claims 1 to 2, characterized in that when the module is stamped out of the band along the contact surfaces the module is glued into the recess in a prepared card body, and when the module is stamped out along an area protruding beyond the contact surfaces the module is molded with a plastic compound to form a card, or the module is incorporated in a multilayer structure that is laminated into a card together with the module.

4. A method for producing data carriers according to claims 1 to 3, characterized in that when the module is glued into the recess in a prepared card body this is done using a contact adhesive or thermally activated adhesive already located on the electronic module.

5. A method for producing data carriers according to claims 1 to 3, characterized in that when the module is glued into the recess in a prepared card body this is done using a liquid adhesive that connects the contact surfaces directly with the card body.

6. A method for producing data carriers according to claims 1 to 3, characterized in that the area protruding beyond the contact surfaces consists of prolongations of the contact surfaces and is crimped in the direction of the integrated circuit to anchor the electronic module within the card during molding with a plastic compound.

7. A method for producing data carriers according to claims 1 to 3, characterized in that the area protruding beyond the contact surfaces is formed by a separate layer on which the contact surfaces lie.

8. A method for producing data carriers according to claims 5 to 6, characterized in that the area protruding beyond the contact surfaces is provided with windows which are penetrated by the card material when the electronic module is anchored in the card.

## Revendications

1. Procédé de fabrication de supports de données munis de modules électroniques, dans lequel les modules électroniques sont fabriqués séparément et comportent un circuit intégré ainsi que des surfaces de contact reliées de façon conductrice au circuit intégré, caractérisé par les étapes suivantes consistant :
- à réaliser une succession d'étapes de procédé pour fabriquer une bande qui contient des modules électroniques complètement neutres, qui sont susceptibles d'être reliés à un corps de carte selon des techniques différentes.
- à réaliser une succession d'étapes d'adaptation spécifiques au module électronique neutre pour une technique déterminée de liaison à un corps de carte succession qui comporte au moins une étape pour l'extraction, adaptée à la technique de liaison choisie, du module hors de la bande, extraction par laquelle le module conserve une configuration extérieure adaptée à la technique de liaison choisie, et
- à relier au corps de carte le module électronique adapté selon la technique de liaison choisie.

2. Procédé de fabrication de supports de données selon la revendication 1, caractérisé en ce que la série des étapes de procédé, au cours desquelles la bande est réalisée, comporte au moins les étapes suivantes consistant :
- à préparer une bande métallique, dont les surfaces de contact sont découpées par poinçonnage, de telle façon qu'elles restent d'abord reliées par des barrettes à la bande métallique,
- à agencer un circuit intégré sur un groupe de surfaces de contact, qui sont nécessaires pour un module électronique, et à établir une liaison conductrice des surfaces de contact avec le circuit intégré,
et en ce que l'étape de procédé pour l'extraction, adaptée à la technique de liaison choisie, du module hors de la bande, consiste en ce que,
- l'on sépare les barrettes qui relient le module à la bande et en ce que, pour au moins une technique de réalisation, on découpe par poinçonnage le module le long des surfaces de contact, puis on l'extrait de la bande et pour au moins une autre technique de réalisation, on découpe par poinçonnage le module le long d'une zone qui fait saillie au-dessus des surfaces de contact.

3. Procédé pour la fabrication de supports de données selon les revendications 1 à 2, caractérisé en ce que lorsqu'on découpe par poinçonnage le module le long des surfaces de contact à partir de la bande, on colle le module dans la cavité d'un corps de carte préparé à l'avance, et en ce que lorsque l'on découpe par poinçonnage le module le long d'une zone, qui fait saillie au-dessus des surfaces de contact, on encastre par injection d'une masse de matière plastique le module pour constituer une carte, ou bien l'on introduit le module dans une structure multicouche, qui est stratifiée avec le module pour constituer une carte.

4. Procédé de fabrication de supports de données selon les revendications 1 à 3, caractérisé en ce que, lorsque le module est collé dans la cavité d'un corps de carte préparé à l'avance, ceci est réalisé à l'aide d'un adhésif collant ou bien susceptible d'être activé par chauffage et qui se trouve déjà sur le module électronique.

5. Procédé pour la fabrication de supports de données selon les revendications 1 à 3, caractérisé en ce que, lorsque le module est collé dans la cavité d'un corps de carte préparé à l'avance, ceci est réalisé à l'aide d'une colle liquide, qui relie les surfaces de contact directement au corps de carte.

6. Procédé pour la fabrication de supports de données selon les revendications 1 à 3, caractérisé en ce que la zone faisant saillie au-dessus des surfaces de contact se compose de prolongements des surfaces de contact et est courbée dans la direction du circuit intégré, afin d'ancrer le module électronique à l'intérieur de la carte au moment où il est encastré par injection d'une masse de matière plastique.

7. Procédé de fabrication de supports de données selon les revendications 1 à 3, caractérisé en ce que la zone faisant saillie au-dessus des surfaces de contact est constituée par une couche séparée, sur laquelle reposent les surfaces de contact.

8. Procédé de fabrication de supports de données selon les revendications 5 à 6, caractérisé en ce que la zone faisant saillie au-dessus des surfaces de contact est munie de fenêtres qui, au moment de l'ancrage du module électronique dans le corps de carte, sont traversées par le matériau de la carte.
